# EUROPEAN PATENT APPLICATION

(11) **EP 4 575 527 A1**
(43) Date of publication of application: **25.06.2025**
(21) Application number: 24214850.0
(22) Date of filing: 22.11.2024
(51) Int. Cl.: G01R 29/08, G01R 29/10

(54) **TESTING SYSTEM AND TESTING METHOD**

(30) Priority: 20.12.2023 US 202363612376 P; 08.10.2024 US 202418908811
(71) Applicant: WaveFidelity Inc., Taipei 103 (TW)
(72) Inventor: Ike, Lin, 334032 Taoyuan City (TW); You-Hua, Lin, 334032 Taoyuan City (TW); Chang-Fa, Yang, 106 Taipei City (TW); Chang-Lun, Liao, 106335 Taipei City (TW)
(74) Representative: Ter Meer Steinmeister & Partner

(57) **Abstract**

A testing system (1) and a testing method are provided. The testing system (1) includes a movable mechanism (120, 121, 122, 123), a testing device (130, 1310), a signal source (140), a nearfield scanner (150), a CR reflector (160), and a processor (180). The testing device (130, 1310) is mounted on the movable mechanism (120, 121, 122, 123) and used for emitting or reflecting an electromagnetic wave (MW). The nearfield scanner (150) is used for measuring the incoming electromagnetic wave (MW). The CR reflector (160) is used for reflecting the electromagnetic wave (MW). The processor (180) is configured to adjust the orientation of the testing device (130, 1310) through the movable mechanism (120, 121, 122, 123), emit the electromagnetic wave (MW) through the signal source (140), and determine the electromagnetic field information of the electromagnetic wave (MW) through the nearfield scanner (150).

## Description

### TECHNICAL FIELD

The present disclosure generally relates to a testing system and a testing method.

### BACKGROUND

With the rapid development of wireless communication technology, the requirements for antenna performance are also increasing. The radiation characteristics of an antenna, such as gain, directivity, and sidelobe level, are crucial to the performance of a communication system. To evaluate the radiation characteristics of an antenna, it is usually necessary to conduct tests under far-field conditions. However, traditional far-field test ranges require a large space, which is not convenient for testing large antennas or in a laboratory environment.

### SUMMARY

Accordingly, the present disclosure is directed to a testing system and a testing method.

According to one or more exemplary embodiments of the disclosure, a testing system includes a movable mechanism, a testing device, a signal source, a nearfield scanner, a compact range (CR) reflector, and a processor. The testing device is mounted on the movable mechanism and used for emitting or reflecting an electromagnetic wave. The signal source is configured to emit the electromagnetic wave. The nearfield scanner is used for measuring the electromagnetic wave. The CR reflector has a parabolic surface used for reflecting the electromagnetic wave. The processor is coupled to the movable mechanism, the signal source, and the nearfield scanner. The processor is configured to adjust the orientation of the testing device through the movable mechanism, emit the electromagnetic wave through the signal source, and determine the electromagnetic field information of the electromagnetic wave through the nearfield scanner.

According to one or more exemplary embodiments of the disclosure, a testing method includes adjusting, through a movable mechanism, the orientation of a testing device mounted on the movable mechanism, emitting an electromagnetic wave, and determining, through a nearfield scanner, electromagnetic field information of the electromagnetic wave reflected or emitted by the testing device or reflected by a CR reflector. The CR reflector has a parabolic surface used for reflecting the electromagnetic wave.

To make the aforementioned more comprehensible, several embodiments accompanied with drawings are described in details as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a block diagram that illustrates a testing system according to an exemplary embodiment of the present disclosure.
FIG. 2 is a schematic diagram that illustrates the top view of the testing system according to an exemplary embodiment of the present disclosure.
FIG. 3 is a schematic diagram that illustrates the side view of the testing system according to an exemplary embodiment of the present disclosure.
FIG. 4A and FIG. 4B are schematic diagrams that illustrate a testing system according to an exemplary embodiment of the present disclosure.
FIG. 5A, FIG. 5B and FIG. 5C are schematic diagrams that illustrate testing devices and movable mechanisms according to an exemplary embodiment of the present disclosure.
FIG. 6A is a schematic diagram that illustrates a near-to-far scenario of a reconfigurable intelligent surface (RIS) according to an exemplary embodiment of the present disclosure.
FIG. 6B is a schematic diagram that illustrates a far-to-far scenario of the RIS according to an exemplary embodiment of the present disclosure.
FIG. 6C is a schematic diagram that illustrates a far-to-near scenario of the RIS according to an exemplary embodiment of the present disclosure.
FIG. 7 is a flow chart that illustrates a testing method according to an exemplary embodiment of the present disclosure.
FIG. 8 is a flow chart that illustrates a calibrating method according to an exemplary embodiment of the present disclosure.
FIG. 9A is a schematic diagram that illustrates a plane-wave scene of a metal plate according to an exemplary embodiment of the present disclosure.
FIG. 9B is a schematic diagram that illustrates a plane-wave scene of a RIS according to an exemplary embodiment of the present disclosure.
FIG. 10A is a schematic diagram that illustrates a plane-wave scene of a metal plate according to an exemplary embodiment of the present disclosure.
FIG. 10B is a schematic diagram that illustrates a plane-wave scene of a RIS according to an exemplary embodiment of the present disclosure.
FIG. 11A is a far-field amplitude distribution diagram of 40 cm ×40 cm passive RIS according to an exemplary embodiment of the present disclosure.
FIG. 11B is a near-field amplitude distribution diagram of the 40 cm×40 cm passive RIS according to an exemplary embodiment of the present disclosure.
FIG. 12A is a far-field amplitude distribution diagram of a 30 cm×30 cm metal plate according to an exemplary embodiment of the present disclosure.
FIG. 12B is a near-field amplitude distribution diagram of the 30 cm×30 cm metal plate according to an exemplary embodiment of the present disclosure.
FIG. 13A is a far-field amplitude distribution diagram of 20 cm×20 cm passive RIS according to an exemplary embodiment of the present disclosure.
FIG. 13B is a near-field amplitude distribution diagram of the 20 cm×20 cm passive RIS according to an exemplary embodiment of the present disclosure.
FIG. 14A is a far-field amplitude distribution diagram of a bistatic clutter according to an exemplary embodiment of the present disclosure.
FIG. 14B is a near-field amplitude distribution diagram of the bistatic clutter according to an exemplary embodiment of the present disclosure.
FIG. 15 is a schematic diagram that illustrates far-field patterns according to an exemplary embodiment of the present disclosure.
FIG. 16A is a schematic diagram that illustrates a bistatic scattered field test evaluation for a 20 cm×20 cm passive RIS according to an exemplary embodiment of the present disclosure.
FIG. 16B is a schematic diagram that illustrates a top view of the bistatic scattered field test evaluation for the 20 cm×20 cm passive RIS according to an exemplary embodiment of the present disclosure.
FIG. 16C is a far-field angular response diagram of the bistatic scattered field test evaluation for the 20 cm×20 cm passive RIS according to an exemplary embodiment of the present disclosure.
FIG. 17A is a schematic diagram that illustrates a bistatic scattered field test evaluation for a 40 cm×40 cm passive RIS according to an exemplary embodiment of the present disclosure.
FIG. 17B is a schematic diagram that illustrates a top view of the bistatic scattered field test evaluation for the 40 cm×40 cm passive RIS according to an exemplary embodiment of the present disclosure.
FIG. 17C is a far-field angular response diagram of the bistatic scattered field test evaluation for the 40 cm×40 cm passive RIS according to an exemplary embodiment of the present disclosure.
FIG. 18A is a near-field amplitude diagram of a 30 cm ×30 cm metal plate according to an exemplary embodiment of the present disclosure.
FIG. 18B is a near-field phase diagram of the 30 cm ×30 cm metal plate according to an exemplary embodiment of the present disclosure.
FIG. 19A is a hologram amplitude diagram of a 30 cm ×30 cm metal plate according to an exemplary embodiment of the present disclosure.
FIG. 19B is a hologram phase diagram of the 30 cm ×30 cm metal plate according to an exemplary embodiment of the present disclosure.
FIG. 20A is a hologram amplitude diagram of 40 cm ×40 cm passive RIS according to an exemplary embodiment of the present disclosure.
FIG. 20B is a hologram phase diagram of the 40 cm ×40 cm passive RIS according to an exemplary embodiment of the present disclosure.
FIG. 21A is a hologram amplitude diagram of a 30 cm ×30 cm metal plate according to an exemplary embodiment of the present disclosure.
FIG. 21B is a hologram phase diagram of the 30 cm ×30 cm metal plate according to an exemplary embodiment of the present disclosure.
FIG. 22 is a flow chart that illustrates a near-field over-the-air (OTA) scanning method according to an exemplary embodiment of the present disclosure.
FIG. 23 is a schematic diagram that illustrates a near-field OTA scan scene according to an exemplary embodiment of the present disclosure.
FIG. 24 is a flow chart that illustrates an effective isotropic radiated power (EIRP) calibrating method according to an exemplary embodiment of the present disclosure.
FIG. 25 is a schematic diagram that illustrates the EIRP calibration scene of a testing device according to an exemplary embodiment of the present disclosure.

### DESCRIPTION OF THE EMBODIMENTS

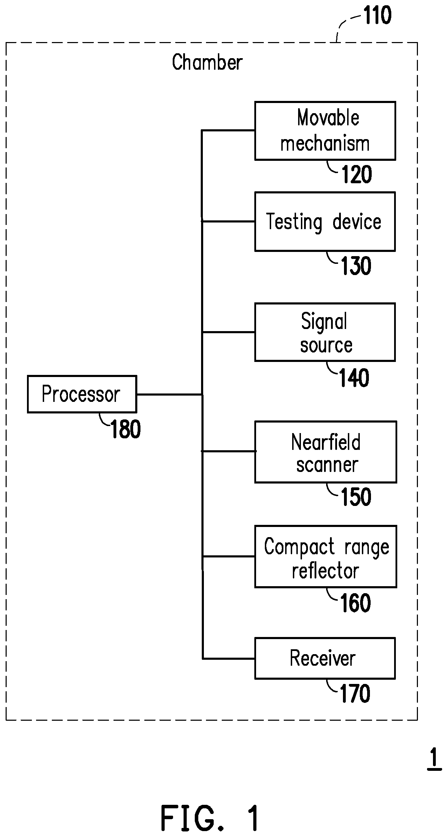

FIG. 1 is a block diagram that illustrates a testing system 1 according to an exemplary embodiment of the present disclosure. Referring to FIG. 1, the testing system 1 includes (but is not limited thereto) a chamber 110, a movable mechanism 120, a testing device 130, a signal source 140, a nearfield scanner 150, a compact range (CR) reflector 160, a receiver 170, and a processor 180.

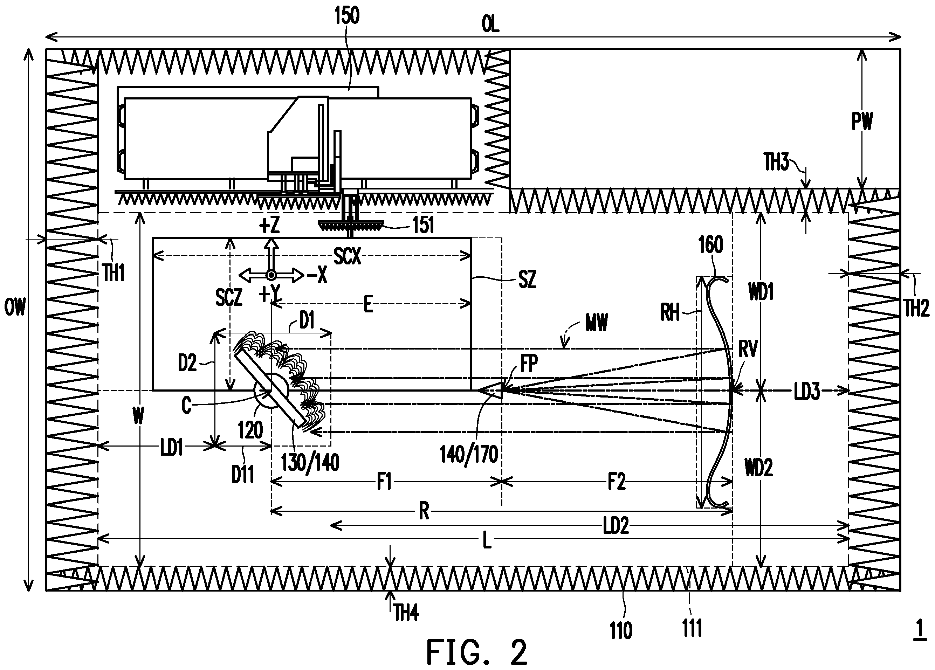

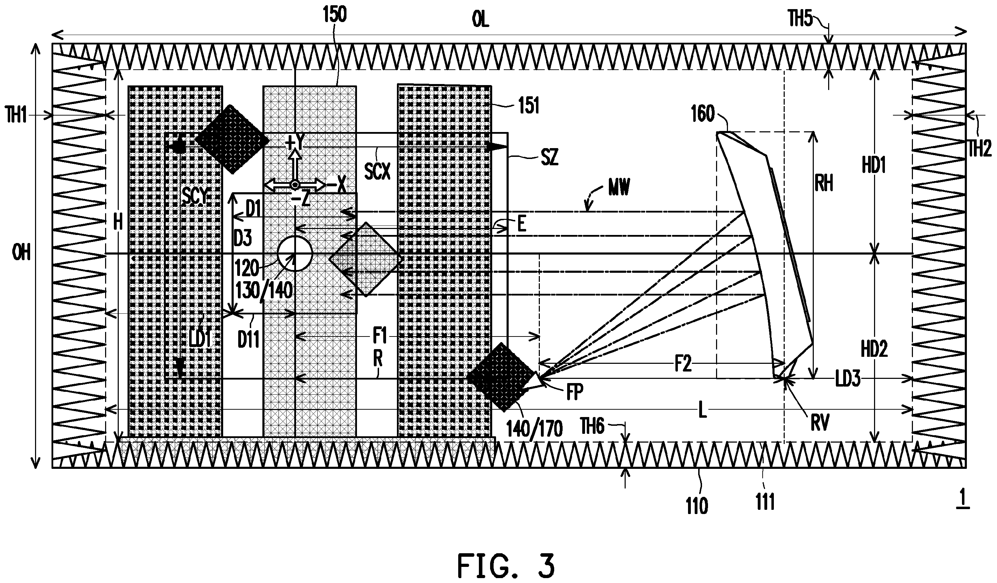

FIG. 2 is a schematic diagram that illustrates the top view of the testing system 1 according to an exemplary embodiment of the present disclosure, and FIG. 3 is a schematic diagram that illustrates the side view of the testing system 1 according to an exemplary embodiment of the present disclosure. Referring to FIG. 2 and FIG. 3, the chamber 110 may be an anechoic chamber, but other types of chambers may be used. One or more radio frequency (RF) absorbing panels may be mounted on the inner walls of the chamber 110. The chamber 110 has an internal space 111. The width W of the internal space 111 corresponding to a first pair of opposite sides (e.g., the left side and the right side as shown in FIG. 2 or FIG. 3) is 3*D, the length L of the internal space 111 corresponding to a second pair of opposite sides (e.g., the upper side and the lower side as shown in FIG. 2) is equal to or larger than 6.5*D, and the height H of the internal space 111 corresponding to a third pair of opposite sides (e.g., the upper side and the lower side as shown in FIG. 3) is 3*D, where D is a reference length larger than 0. For example, D is 50, 60, or 80 centimeters (cm). The size of the chamber 110 is the width OW × the length OL × the height OH. For example, the length OL is equal to or larger than 6.5*D+60 cm (i.e., the sum of the length L and the thicknesses TH1 and TH2), the width OW is larger than 3*D+140 cm (i.e., the sum of the width W, the thicknesses TH3 and TH4, and the extended width PW), and the height OH is larger than 3*D+40 cm (i.e., the sum of the height H and the thicknesses TH5 and TH6). However, the sizes of the chamber 110 and/ or the internal space 111 may be different for other requirements.

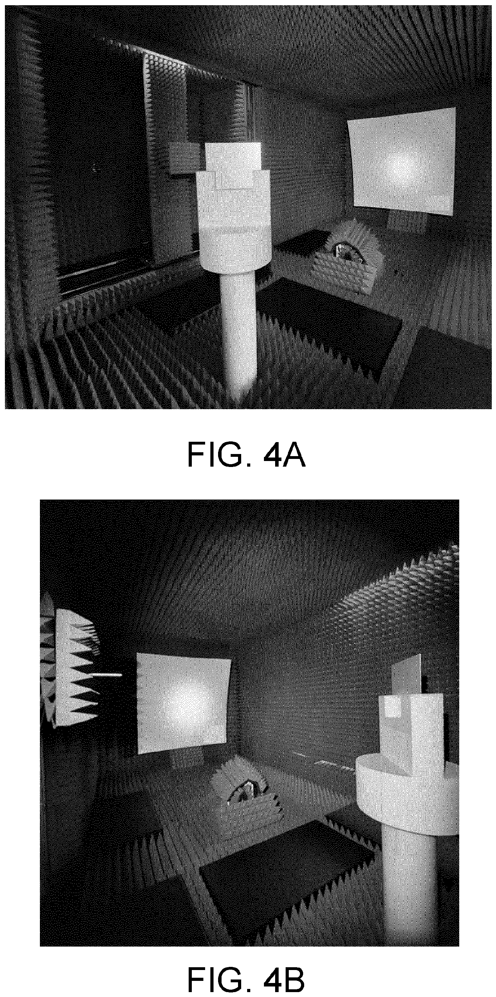

For example, FIG. 4A and FIG. 4B are schematic diagrams that illustrate a testing system 1 according to an exemplary embodiment of the present disclosure. FIG. 4A and FIG. 4B shows the views inside the internal space of the chamber 110.

Referring to FIG. 2 and FIG. 3, the test zone (may be called the quiet zone) TZ is located, with its center position specified by C in FIG. 2, within the internal space 111. The diameters D1 and D2 of the test zone TZ are D. The distances between the first pair of opposite sides and their respective nearest boundaries of the test zone TZ are both D. The distance LD1 between one of the second pair of opposite sides and its respective nearest boundary of the test zone TZ is D, and the distance LD2 between another of the second pair of opposite sides and its respective nearest boundary of the test zone TZ is equal to 4.5*D or larger than 4.5*D. The distances between the pair of opposite third sides and their respective nearest boundaries of the test zone TZ are both D. However, the size of the test zone TZ may be different for other requirements. For example, D may be 80 cm for 4.7-60 GHz of the frequency range of the CR reflector 160. D may be larger than 60 cm for 4.0-4.7 GHz of the frequency range of the CR reflector 160. D may be larger than 50 cm for 3.3-4.0 GHz of the frequency range of the CR reflector 160. D is the size of the testing zone TZ and is related to the operating frequency of the CR reflector 160.

The movable mechanism 120 may be a multi-axis robot arm, a multi-degree of freedom mechanism, a height adjusting platform, a slide rail, a rotary table, a screw rod, a motor, or a cylinder stator and other types of mechanical components that may drive a mounted element to move and/or rotate. The movable mechanism 120 may be located within the internal space 111.

The testing device 130 may be a metal plate, any type of antenna, any type of reflective/ transmissive surfaces (including reconfigurable intelligent surface, RIS), or a scatter. The testing device 130 is used for emitting or reflecting an electromagnetic wave. For example, the metal plate, the RIS, or the scatter reflects the electromagnetic wave. Alternatively, the antenna emits the electromagnetic wave. The testing device 130 is located within the internal space 111. The testing device 130 is mounted on the movable mechanism 120.

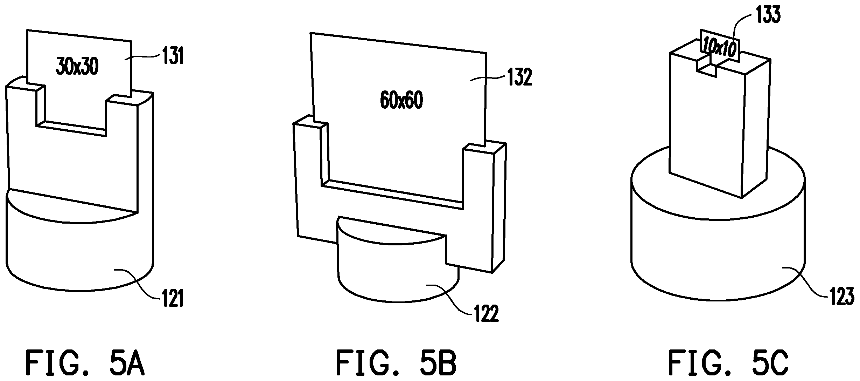

For example, FIG. 5A, FIG. 5B and FIG. 5C are schematic diagrams that illustrate testing devices 131, 132, and 133 and movable mechanisms 121, 122, and 123 according to an exemplary embodiment of the present disclosure. Referring to FIG. 5A, the movable mechanism 121 is a rotary table having a stand on which the testing device 131 (e.g., a 30 cm ×30 cm metal plate) is mounted. Referring to FIG. 5B, the movable mechanism 122 is a rotary table having a stand on which the testing device 132 (e.g., a 60 cm ×60 cm metal plate) is mounted. Referring to FIG. 5C, the movable mechanism 123 is a rotary table having a stand on which the testing device 133 (e.g., a 10 cm × 10 cm metal plate) is mounted.

The signal source 140 may be a feed antenna or any antenna under test (AUT)/ active electronically scanned array (AESA). The signal source 140 is located within the internal space 111.

Referring to FIG. 2 and FIG. 3, the nearfield scanner 150 is located inside the chamber 110. The nearfield scanner 150 has a probe 151. The probe 151 stands vertically at one of the first pair of opposite sides (e.g., the upper side and the lower side as shown in FIG. 2) of the internal space 111. The probe 151 may be movable along the axis X and/or the axis Y by a mechanism.

Referring to FIG. 2, the nearfield scanner 150 is used for measuring the electromagnetic wave. For example, the nearfield scanner 150 measures the radiation characteristics of the testing device 130. The collected data of the nearfield scanner 150 such as amplitude and phase data may be converted into a far-field radiation pattern through mathematical algorithms, such as the fast Fourier transform (FFT) and probe compensation. The far-field radiation pattern reveals the radiation characteristics in the far field, including gain, directivity, beamwidth, and/or sidelobe levels.

In one embodiment, referring to FIG. 2 and FIG. 3, the nearfield scanner 150 is configured with a scan coverage plane SZ of SCX in width (along X axis direction) by SCY in height (along Y axis direction). The scan coverage plane SZ, where the probe antenna tip of nearfield scanner is to move on, is configured, along -Z axis direction, to be at a separation distance SCZ of 1.3*D from the center of test zone TZ, C, of the internal space 111. The scan coverage plane extends no more than 1.75*D (i.e. the length E) from a line connected between position C, the center of the test zone (quiet zone center) and the nearfield scanner 150 (along the negative Z axis direction), with a length SCX of the scan coverage plane SZ corresponding to the first pair of opposite sides is equal to or larger than 2.75*D (extendable depending on available chamber interior space), and a height SCY of the scan coverage plane SZ corresponding to the second pair of opposite sides is equal to or larger than 2*D.

Specifically, the distance D11 between the center C of the test zone TZ and its left side shown in FIG. 2 is 1/2*D. The distance WD1 between the center C of the test zone TZ and one of the first pair of opposite sides (e.g., the upper side and the lower side as shown in FIG. 2) of the internal space 111 equals the distance WD2 between the center C of the test zone TZ and another one of the first pair of opposite sides (e.g., the upper side and the lower side as shown in FIG. 2) of the internal space 111. The distance WD1 and WD2 may be equal to or larger than 1.5*D. The distance HD1 between the center C of the test zone TZ and one of the third pair of opposite sides (e.g., the upper side and the lower side as shown in FIG. 3) of the internal space 111 equals the distance HD2 between the center C of the test zone TZ and another one of the third pair of opposite sides (e.g., the upper side and the lower side as shown in FIG. 3) of the internal space 111. The distance HD1 and HD2 may be equal to or larger than 1.5*D. The maximal down-range scan extent in nearfield scanner 150 negative -horizontal scan direction (e.g., the negative direction of the axis X) with respect to the center C of the test zone TZ for minimizing compact range (CR) feed spillover is: E =1.75*D. Optimized cross-range separation distance at probe 151 antenna tip along the axis Z of the nearfield scanner 150, aligned perpendicularly to broadside/down-range direction of CR, measured from the center C of the test zone TZ for minimizing CR reflector edge specular reflection and maximizing visible yet reliable angular range of target/unit under test (UUT) bi-static far-field scattering responses is: SCZ=1.3*D. The suggested minimal horizontal/down-range scan coverage of the side-deployed nearfield scanner 150 (along the direction of the axis Z, aligned parallelly with broadside/down-range direction of CR) for better visible and reliable horizontal angular coverage of target/UUT bi-static far-field scattering response performance is: SCX ≥ 2.75*D. Furthermore, suggested minimal vertical/cross-range scan coverage SZ of the nearfield scanner 150 (along the direction of the axis Y, aligned perpendicularly to broadside/down-range direction of CR), with center of vertical scan coverage aligned at the same height of the center C of the test zone TZ, for better visible and reliable vertical angular coverage of target/UUT bi-static far-field scattering response performance is: SCY ≥ 2.0*D.

Referring to FIG. 2 and FIG. 3, the CR reflector 160 is located within the internal space 111. The CR reflector 160 may be a roll-edged reflector or other compact antenna test range (CATR) reflector. The length RH of the CR reflector 160 is 2*D. The size of the CR reflector 160 is 2*D × 2*D. The CR reflector 160 has a parabolic surface as shown in FIG. 2 and FIG. 3 used for reflecting the electromagnetic wave. The parabolic surface of the CR reflector 160 has a focal point FP. The distance R between the CR reflector 160 and the testing device 130 is equal to or larger than 4*D. The distance F1 between the testing device 130 and the focal point FP is equal to or larger than 2*D. The focal length F2 of the CR reflector 160 is equal to or larger than 2*D. The distance LD3 between the vertex RV of the CR reflector 160 and one of the first pair of opposite sides (e.g., the right side as shown in FIG. 2 or FIG. 3) is about D. However, the size of the CR reflector 160 may be different for other requirements.

In one embodiment, the signal source 140 is located at the focal point FP. The signal source 140 is located between the testing device 130 and the CR reflector 160, and the testing device 130 reflects the electromagnetic wave reflected by the CR reflector 160.

In another embodiment, the testing device 130 is the signal source 140. The CR reflector 160 reflects the electromagnetic wave emitted by the testing device 130. The testing device 130 may be located within the testing zone TZ, the scan coverage SC, or other locations inside the internal space 111.

In one embodiment, the frequency range operated by the CR reflector 160 is 3.3-60 GHz and may be expandable to 90 GHz.

In some embodiments, the receiver 170 is deployed. The receiver 170 may be an antenna or other RF receiver. Referring to FIG. 2 and FIG. 3, the receiver 170 is located within the internal space 111 of the chamber 110. The receiver 170 is located at the focal point FP of the parabolic surface of the CR reflector 160.

Referring to FIG. 1, the processor 180 is coupled to the movable mechanism 120, the signal source 140, the nearfield scanner 150, and the receiver 170. In some embodiments, the processor 180 may be coupled to the testing device 130 while testing device 130 is serving as the signal source 140. The processor 180 (e.g., having processing circuitry) may be a central processing unit (CPU), a graphic processing unit (GPU), a microcontroller, a micro control unit (MCU), an application-specific integrated circuit (ASIC), etc. The processor 180 may call and run a computer program from memory to implement the method in the embodiment of the disclosure.

In order to facilitate understanding of an operation flow of the embodiment of the disclosure, multiple embodiments are provided below to describe a flow of using the testing system 1 in detail. In the following description, the method of the disclosure is described with reference of various devices, elements, and modules of the testing system 1. Various flows of the method may be adjusted according to an actual application, which is not limited by the disclosure.

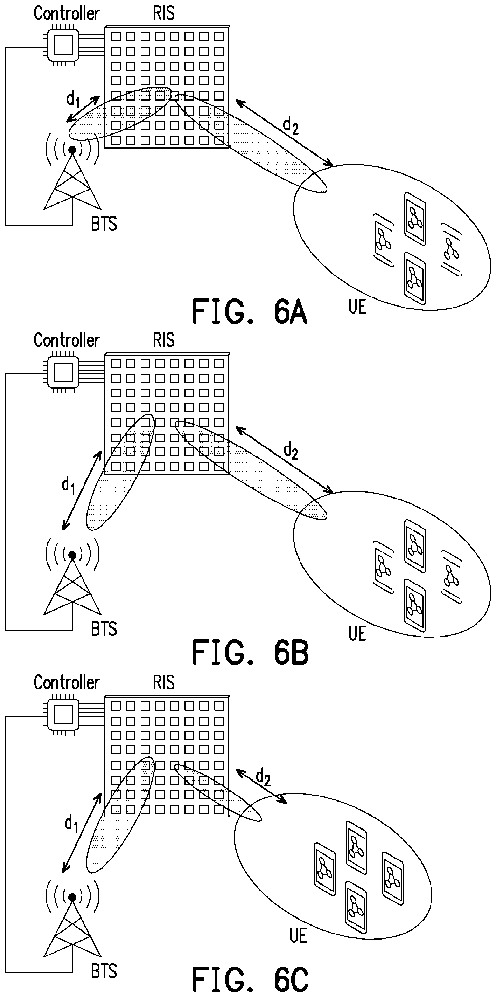

There are multiple scenarios of the usage of a RIS. For example, FIG. 6A is a schematic diagram that illustrates a near-to-far scenario of a RIS according to an exemplary embodiment of the present disclosure. Referring to FIG. 6A, the controller may be connected to the RIS and the base transceiver station (BTS). The BTS is close to the RIS, and one or more user equipment (UEs) are distant from the RIS. That is, the distance d₁ between the BTS and the RIS is much less than the distance d₂ between the RIS and one or more user equipment (UEs). In this scenario, the test of the field distribution is operated in conventional reflect array mode.

FIG. 6B is a schematic diagram that illustrates a far-to-far scenario of the RIS according to an exemplary embodiment of the present disclosure. Referring to FIG. 6B, the BTS is distant from the RIS, and one or more user equipment (UEs) are distant from the RIS. That is, the distance d₁ and the distance d₂ meet far-field conditions. In this scenario, the test of the field distribution is operated in radar cross-section (RCS) mode.

FIG. 6C is a schematic diagram that illustrates a far-to-near scenario of the RIS according to an exemplary embodiment of the present disclosure. Referring to FIG. 6C, the BTS is distant from the RIS, and one or more user equipment (UEs) are close to the RIS. That is, the distance d₁ meets far-field conditions, and the distance d₂ is in the near-field region. In this scenario, the test of the field distribution is operated in radar cross-section (RCS) mode and near-field holography methods.

In the scenarios of FIG. 6B and FIG. 6C, the electromagnetic wave of planar wavefronts propagated from BTS at a far-away distance.

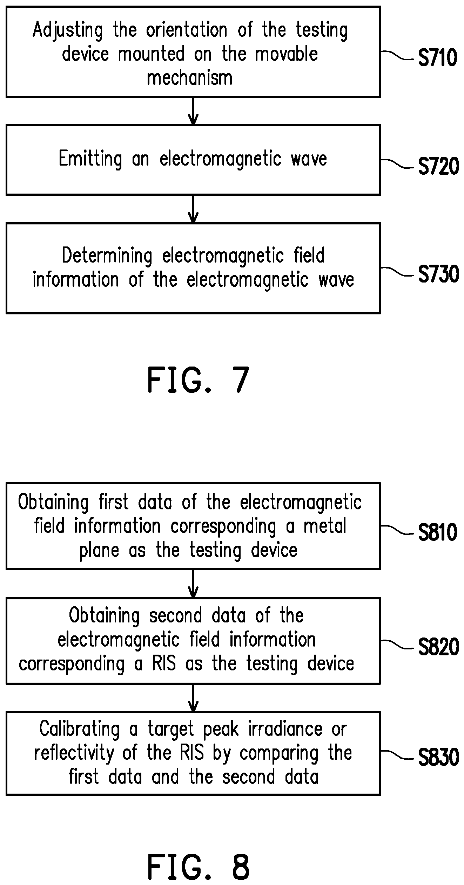

FIG. 7 is a flow chart that illustrates a testing method according to an exemplary embodiment of the present disclosure. Referring to FIG. 7, the processor 180 adjusts the orientation of the testing device 130 through the movable mechanism 120 (step S710). Referring to FIG. 2, the testing device 130 may be rotated at a plane of the axes X and Z. The processor 180 may send an instruction to control the movable mechanism 120. In one embodiment, the processor 180 may adjust the orientation of the testing device 130 to a desired direction through the movable mechanism 120. The desired direction makes an angle within a range greater than 0 degree and less than 90 degrees relative to the axis X, and the desired direction makes an angle greater than 0 degree and less than 90 degrees relative to the axis Z, where the axis X is vertical to the axis Z.

In another embodiment, the desired direction makes an angle within a range greater than 0 degree and less than 90 degrees (or larger than -90 degrees) relative to the axis Z. In still another embodiment, the desired direction makes an angle being 0 degree relative to the axis X. That is the largest surface of the testing device 130 faces toward the CR reflector 160.

In one embodiment, the processor 180 may adjust the position of the testing device 130 through the movable mechanism 120 to be located within the test zone TZ. The testing device 130 may be movable through the movable mechanism 120 at a plane of axes X and Z.

In another embodiment, the processor 180 may adjust the position of the testing device 130 through the movable mechanism 120 to be located within the scan coverage SZ of the nearfield scanner 150.

Referring to FIG. 7, the processor 180 emits the electromagnetic wave through the signal source 140 (step S720). Specifically, the processor 180 may send an instruction to control the signal source 140. Then, the signal source 140 may transmit wireless signals with the electromagnetic wave. Referring to FIG. 2, in one embodiment, the signal source 140 is located at the focal point FP of the CR reflector 160, and the signal source 140 emits the electromagnetic wave toward the vertex RV of the CR reflector 160 along the axis X. Then, a plane wave would be formed after the electromagnetic wave is reflected by the CR reflector 160. In another embodiment, the signal source 140 may be located at any location inside the chamber 110 other than the focal point FP and emit the electromagnetic wave toward any desired direction. Then, the electromagnetic wave may be propagated to the focal point FP of the CR reflector 160 after the electromagnetic wave is reflected by the CR reflector 160.

Referring to FIG. 7, the processor 180 determines electromagnetic field information of the electromagnetic wave through the nearfield scanner 150 (step S730). For example, the nearfield scanner 150 collects the amplitude and phase data of the electromagnetic wave. The processor 180 or the nearfield scanner 150 may transform the amplitude and phase data to an amplitude distribution, a far-field angular response, a near-field amplitude and/ or phase, 3-D far-field data, a hologram amplitude, or other measurement results (i.e., the electromagnetic field information).

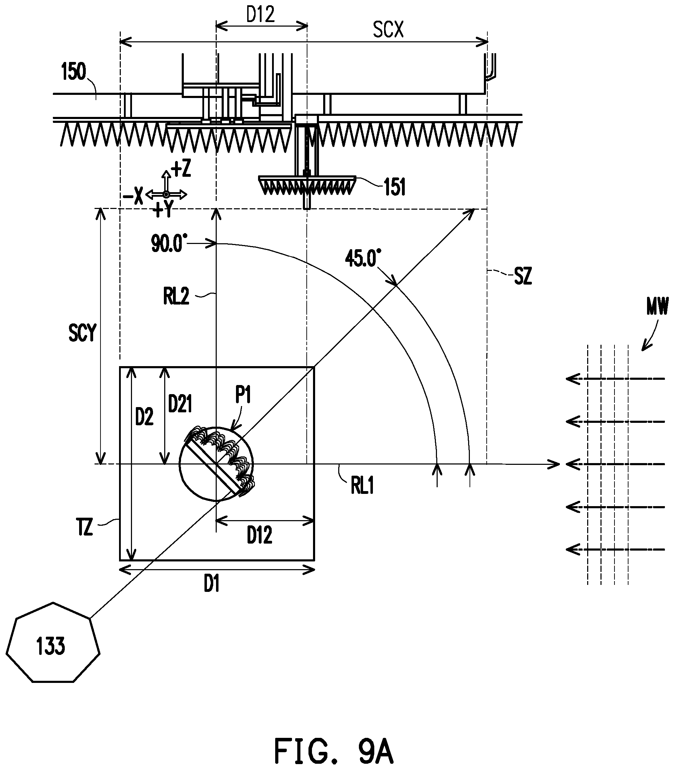

FIG. 8 is a flow chart that illustrates a calibrating method according to an exemplary embodiment of the present disclosure. Referring to FIG. 8, the processor 180 may obtain the first data of the electromagnetic field information corresponding to a metal plane serving as the testing device 130 through the nearfield scanner 150 (step S810). FIG. 9A is a schematic diagram that illustrates a plane-wave scene of a metal plate 131 according to an exemplary embodiment of the present disclosure. Referring to FIG. 9A, in the plane wave scenario, the metal plate 131 is located at the position P1 within the testing zone TZ. There is a distance D12 from the position P1 to the right side of the testing zone TZ along the axis X, and there is another distance D21 from the position P1 to the upper side of the testing zone TZ along the axis Z. The orientation of the testing device 130 (e.g., the metal plate 133) to the desired direction, where the desired direction makes an angle within a range greater than 0 degree and less than 90 degrees relative to the first reference line RL1, and the desired direction makes an angle greater than 0 degrees and less than 90 degrees relative to the second reference line RL2. The first reference line RL1 is parallel to a line connected between the testing device 130 and the CR reflector 160, the second reference line RL2 is parallel to a line connected between the testing device 130 and the nearfield scanner 150. In one embodiment, the first reference line RL1 is vertical to the second reference line RL2. For example, the desired direction makes an angle of 45 degrees relative to the first reference line RL1. The nearfield scanner 150 collects the first data of the electromagnetic field information of the metal plate 131. The data could be amplitude and/ or phase data.

The metal plate 131 is, for example, square in shape and 30cm×30cm×3mm in size. The metal plate 131 would be considered as a calibration reference of peak irradiance/reflectivity at the position P1 where RIS/UUT is to be deployed within the quiet zone region of test range such as the testing zone TZ. Specular reflection condition of 35-45 degrees inclined to 0 degree of incidence angle of incoming planar wavefronts for the metal plate 131 is kept to obtain optimized reflectivity reference.

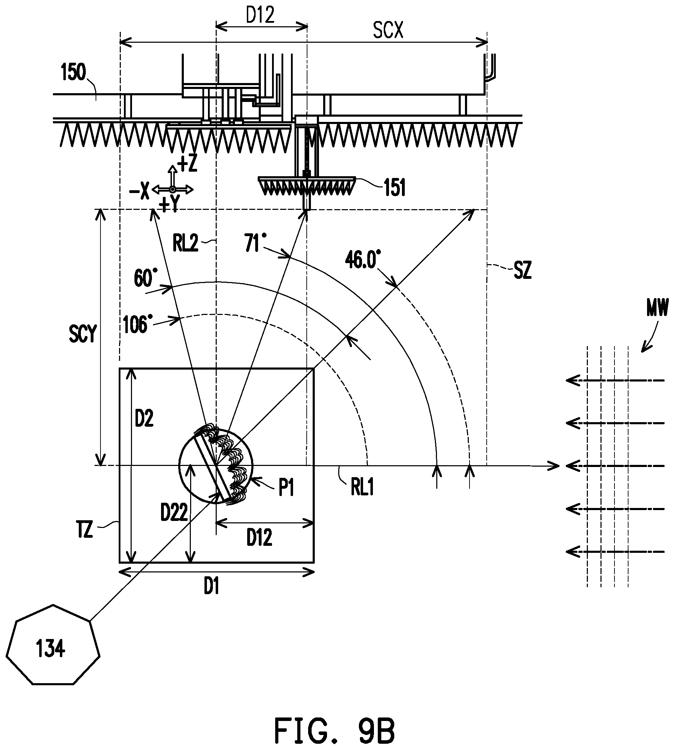

Referring to FIG. 8, the processor 180 may obtain the second data of the electromagnetic field information corresponding to a RIS serving as the testing device 130 through the nearfield scanner 150 (step S820). FIG. 9B is a schematic diagram that illustrates a plane-wave scene of a RIS 134 according to an exemplary embodiment of the present disclosure. Referring to FIG. 9B, the RIS 134 is moved to the testing zone TZ at the position P1. There is another distance D22 from the position P1 to the lower side of the testing zone TZ along the axis Z. The orientation of the testing device 130 (e.g., the RIS 134) is rotated to the desired direction, where the desired direction makes an angle within a range greater than 0 degree and less than 90 degrees relative to the first reference line RL1, and the desired direction makes an angle greater than 0 degree and less than 90 degrees relative to the second reference line RL2. For example, the desired direction makes an angle of 46 degrees relative to the first reference line RL1. The nearfield scanner 150 collects the second data of the electromagnetic field information of the RIS 134.

Referring to FIG. 8, the processor 180 may calibrate a target peak irradiance or reflectivity of the RIS by comparing the first data and the second data (step S830). Specifically, the peak irradiance of RIS 134/UUT deployed within the same location of the test range is determined by comparing it with the metal plate 131 illuminated by the same train of planar wavefronts of emulated OTA signature as shown in FIG. 9A. The unknown RIS 134/UUT is deployed so that the reflected/scanned beams of the operational RIS still fall within the scan coverage SZ of the side-deployed nearfield scanner 150 and can result in reliable 3D far-field angular power spectrum of the UUT. The difference between the first data and the second data could be used to modify the configuration of the RIS 134/UUT for performance optimization.

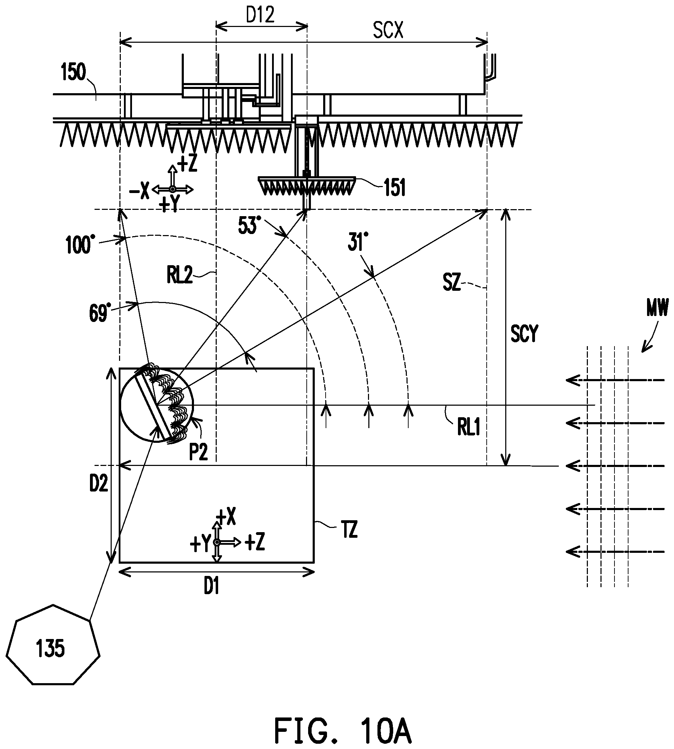

FIG. 10A is a schematic diagram that illustrates a plane-wave scene of a metal plate 135 according to an exemplary embodiment of the present disclosure. Referring to FIG. 10A, the metal plate 135 is, for example, square in shape and 30cm×30cm×3mm in size. The metal plate 135 would be considered as a calibration reference of peak irradiance/reflectivity at the position P2 where RIS/UUT is to be deployed within the quiet zone region of test range such as the testing zone TZ. The position P2 is located at the upper left corner of the testing zone TZ. Specular reflection condition of 35-45 degrees inclined to 0 degree incidence of incoming planar wavefronts for the metal plate 135 is kept to obtain optimized reflectivity reference. The desired direction of the metal plate 135 makes an angle within a range greater than 0 degree and less than 180 degrees relative to the first reference line RL1. For example, 31 degrees as shown in FIG. 10A. The nearfield scanner 150 collects the first data of the electromagnetic field information of the metal plate 135.

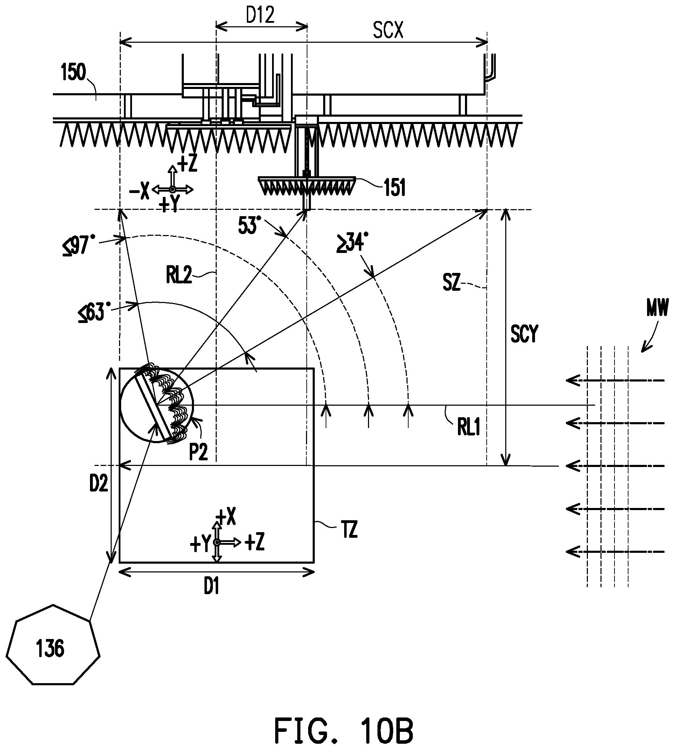

FIG. 10B is a schematic diagram that illustrates a plane-wave scene of a RIS 136 according to an exemplary embodiment of the present disclosure. Referring to FIG. 10B, the RIS 136 is moved to the testing zone TZ at the position P2. The orientation of the testing device 130 (e.g., the RIS 136) is rotated to the desired direction, where the desired direction makes an angle within a range greater than 0 degrees and less than 90 degrees relative to the first reference line RL1. For example, the desired direction makes an angle of 34 degrees relative to the first reference line RL1. The nearfield scanner 150 collects the second data of the electromagnetic field information of the RIS 136. Also, the peak irradiance of RIS 136/UUT deployed within the same location of the test range is determined by comparing it with the metal plate 135 illuminated by the same train of planar wavefronts of emulated OTA signature as shown in FIG. 10A. The unknown RIS 136/UUT is deployed so that the reflected/scanned beams of the operational RIS still fall within the scan coverage SZ of the side-deployed nearfield scanner 150 and can result in reliable 3D far-field angular power spectrum of the UUT. The difference between the first data and the second data could be used to modify the configuration of the RIS 136/UUT for performance optimization.

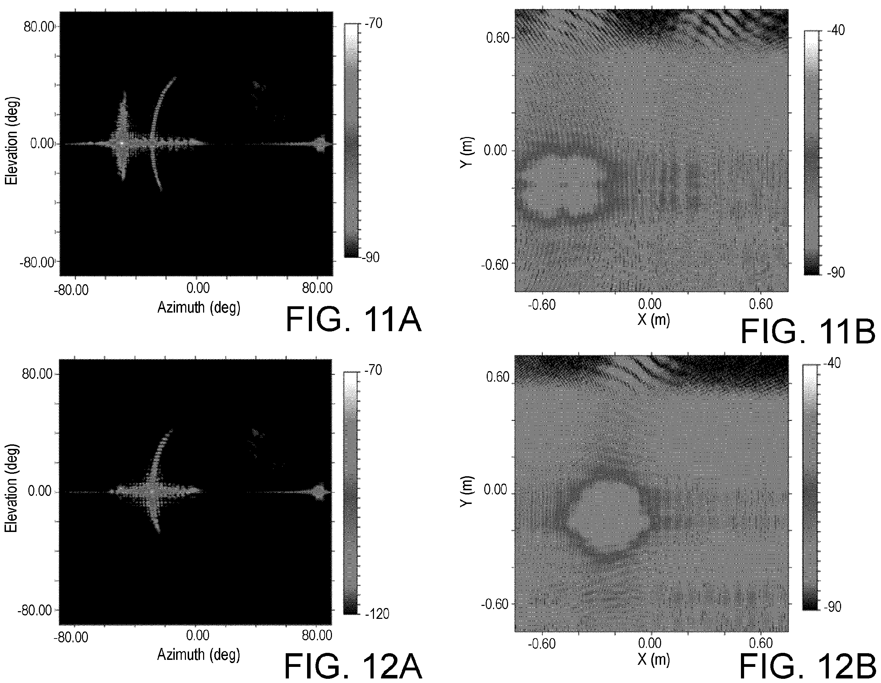

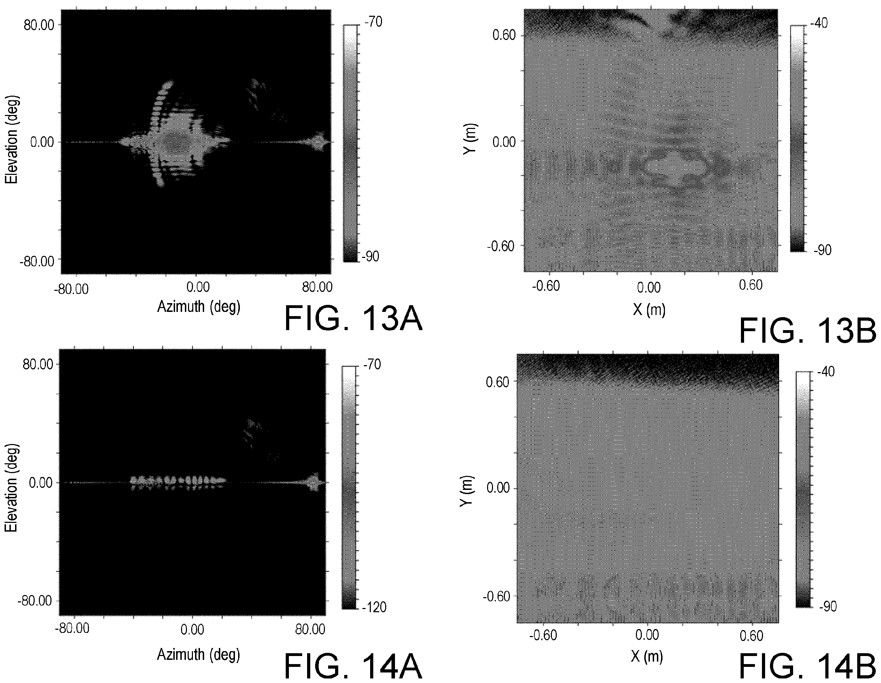

FIG. 11A is a far-field amplitude distribution diagram of 40 cm×40 cm passive RIS according to an exemplary embodiment of the present disclosure, and FIG. 11B is a near-field amplitude distribution diagram of the 40 cm×40 cm passive RIS according to an exemplary embodiment of the present disclosure. FIG. 12A is a far-field amplitude distribution diagram of a 30 cm×30 cm metal plate according to an exemplary embodiment of the present disclosure, and FIG. 12B is a near-field amplitude distribution diagram of the 30 cm×30 cm metal plate according to an exemplary embodiment of the present disclosure. FIG. 13A is a far-field amplitude distribution diagram of 20 cm×20 cm passive RIS according to an exemplary embodiment of the present disclosure, and FIG. 13B is a near-field amplitude distribution diagram of the 20 cm×20 cm passive RIS according to an exemplary embodiment of the present disclosure. FIG. 14A is a far-field amplitude distribution diagram of a bistatic clutter according to an exemplary embodiment of the present disclosure, and FIG. 14B is a near-field amplitude distribution diagram of the bistatic clutter according to an exemplary embodiment of the present disclosure. These figures are measurement results of bistatic tests in which the incidence angle is 30 degrees. In FIG. 11A, the electromagnetic field strength is concentrated at about -50 and -30 degrees in azimuth. In FIG. 12A, the electromagnetic field strength is concentrated at about -30 degrees in azimuth. In FIG. 13A, the electromagnetic field strength is concentrated from 20 to -50 degrees in azimuth. In FIG. 14A, the electromagnetic field strength is concentrated from 20 to -50 degrees in azimuth. It should be noted, as in FIGs' 11A, 12A, 13A, and 14A, that leaked energy at about 80 degrees in azimuth is the range clutter resulted from the signal source 140 reflected by the rolled-edge boundary geometry of the CR reflector 160 at the nearfield scanner 150 side. Furthermore, FIG. 11B, FIG. 12B, FIG. 13B, and FIG. 14 shows the electromagnetic field strength at the X-Y plane over the scan coverage plane SZ. All amplitude and phase distribution diagrams shown in FIGs' 11s, 12s, 13s, and 14s have been based in the sense of recording vertically polarized field component using nearfield probe antenna 151 following by emitting vertically polarized RF source, MW, from the signal source 140 at the CR reflector focus side, FP, according to an exemplary embodiment of the present disclosure.

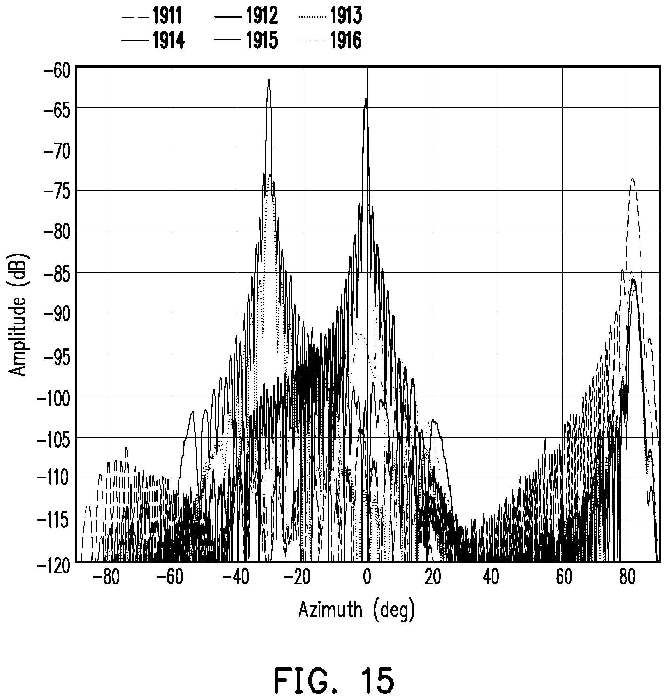

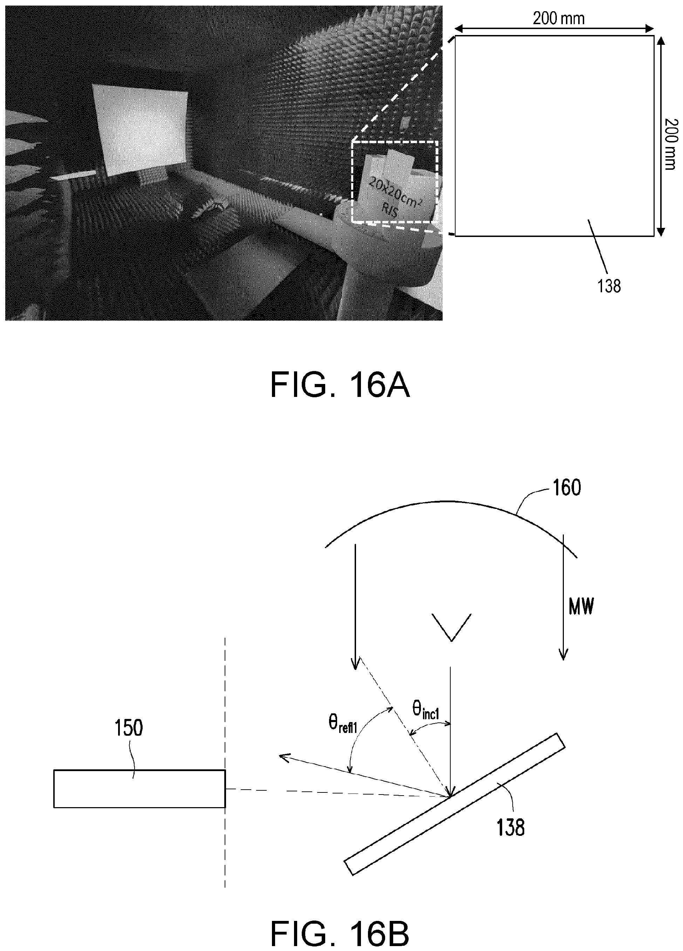

FIG. 15 is a schematic diagram that illustrates far-field patterns in the sense of recording vertically polarized field component using nearfield probe antenna 151 following by emitting vertically polarized RF source, MW, from the signal source 140 at the CR reflector focus side, FP, according to an exemplary embodiment of the present disclosure. Referring to FIG. 15, there are multiple far-field patterns of reflected beams for metal plates of various sizes positioned at 30 degrees or 45 degrees of incidence angle. The far-field pattern 1911 is measured corresponding to the range spillover/ clutter. The far-field pattern 1912 is measured on the 60 cm× 60 cm metal plate at 45 degrees of incidence angle. The far-field pattern 1913 is measured on the 30 cm× 30 cm metal plate at 30 degrees of incidence angle. The far-field pattern 1914 is measured on the 60 cm× 60 cm metal plate at 30 degrees of incidence angle. The far-field pattern 1915 is measured on the 10 cm× 10 cm metal plate at 45 degrees of incidence angle. The far-field pattern 1916 is measured on the 30 cm× 30 cm metal plate at 45 degrees of incidence angle. Each pattern has two peaks corresponding to its specular reflection angle from the incident electromagnetic wavefront of the CR reflector 160 to the specific metal plate and the range clutter of signal source 140 without being reflected by the metal plate, respectively. The associated peak angular responses from these metal plates of various sizes in FIG. 15 will be used as calibration references of bi-static RCS for the testing device 130 bistatic scattering property characterization. FIG. 16A is a schematic diagram that illustrates a bistatic scattered field test evaluation for a 20 cm×20 cm passive RIS according to an exemplary embodiment of the present disclosure. Referring to FIG. 16A, the testing device 130 is the 20 cm×20 cm passive RIS 138. FIG. 16B is a schematic diagram that illustrates a top view of the bistatic scattered field test evaluation for the 20 cm×20 cm passive RIS according to an exemplary embodiment of the present disclosure. Referring to FIG. 16B, the incident angle θ_{inc1} of the field is 30 degrees, and the reflect angle θ_{refl1} of the field is -45 degrees.

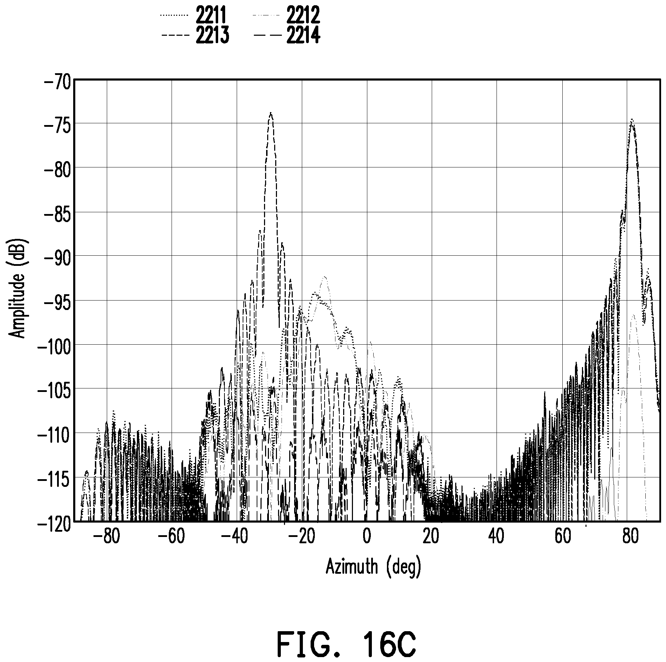

FIG. 16C is a far-field angular response diagram of the bistatic scattered field test evaluation for the 20 cm×20 cm passive RIS according to an exemplary embodiment of the present disclosure. Referring to FIG. 16C, there are multiple far-field angular responses positioned at 30 degrees of incidence angle. The far-field angular response 2211 is measured by cutting through the peak angular response of the range clutter. The far-field angular response 2212 is measured by cutting through the peak angular response of the 20 cm×20 cm passive RIS. The far-field angular response 2213 is measured by cutting through the peak angular response of the 30 cm× 30 cm metal plate at 30 degrees of incidence angle. The far-field angular response 2214 is measured by cutting through the peak angular response of the range clutter alone at 30 degrees of incidence angle. All amplitude distribution plots shown in FIG. 16C have been based in the sense of recording vertically polarized field component using nearfield probe antenna 151 following by emitting vertically polarized RF source, MW, from the signal source 140 at the CR reflector focus side, FP, according to an exemplary embodiment of the present disclosure.

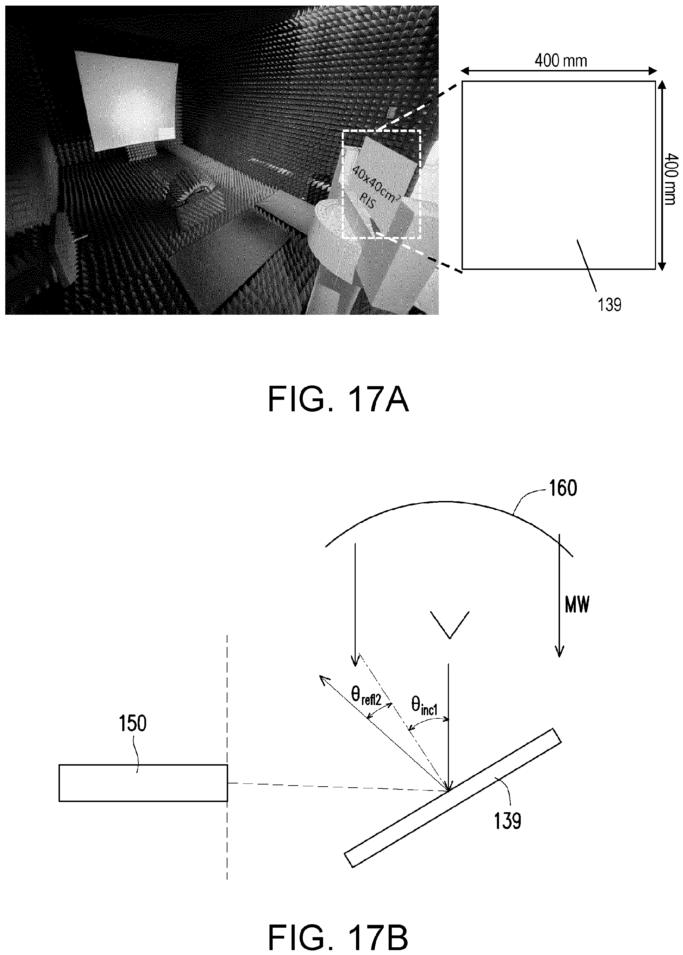

FIG. 17A is a schematic diagram that illustrates a bistatic scattered field test evaluation for a 40 cm×40 cm passive RIS according to an exemplary embodiment of the present disclosure. Referring to FIG. 17A, the testing device 130 is the 40 cm×40 cm passive RIS 139. FIG. 17B is a schematic diagram that illustrates a top view of the bistatic scattered field test evaluation for the 40 cm×40 cm passive RIS according to an exemplary embodiment of the present disclosure. Referring to FIG. 17B, the incident angle θ_{inc1} of the field is 30 degrees, and the reflect angle θ_{refl2} of the field is -10 degrees.

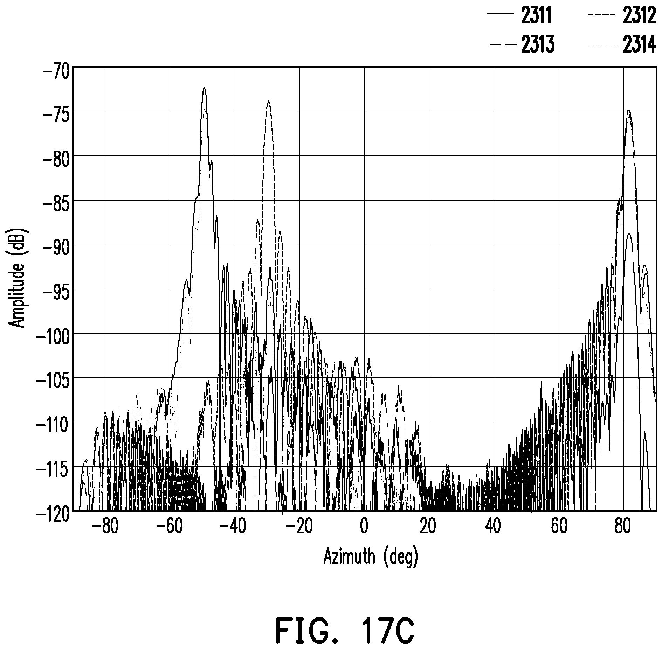

FIG. 17C is a far-field angular response diagram of the bistatic scattered field test evaluation for the 40 cm×40 cm passive RIS according to an exemplary embodiment of the present disclosure. Referring to FIG. 17C, there are multiple far-field angular responses positioned at 30 degrees of incidence angle. The far-field angular response 2311 is measured by cutting through the peak angular response of the 40 cm×40 cm passive RIS. The far-field angular response 2312 is measured on the 30 cm× 30 cm metal plate at 30 degrees of incidence angle. The far-field angular response 2313 is measured by cutting through the peak angular response of the range clutter alone at 30 degrees of incidence angle. The far-field angular response 2314 is measured of the 40 cm×40 cm passive RIS by cutting through the peak angular response of the range clutter. All amplitude distribution plots shown in FIG. 17C have been based in the sense of recording vertically polarized field component using nearfield probe antenna 151 following by emitting vertically polarized RF source, MW, from the signal source 140 at the CR reflector focus side, FP, according to an exemplary embodiment of the present disclosure.

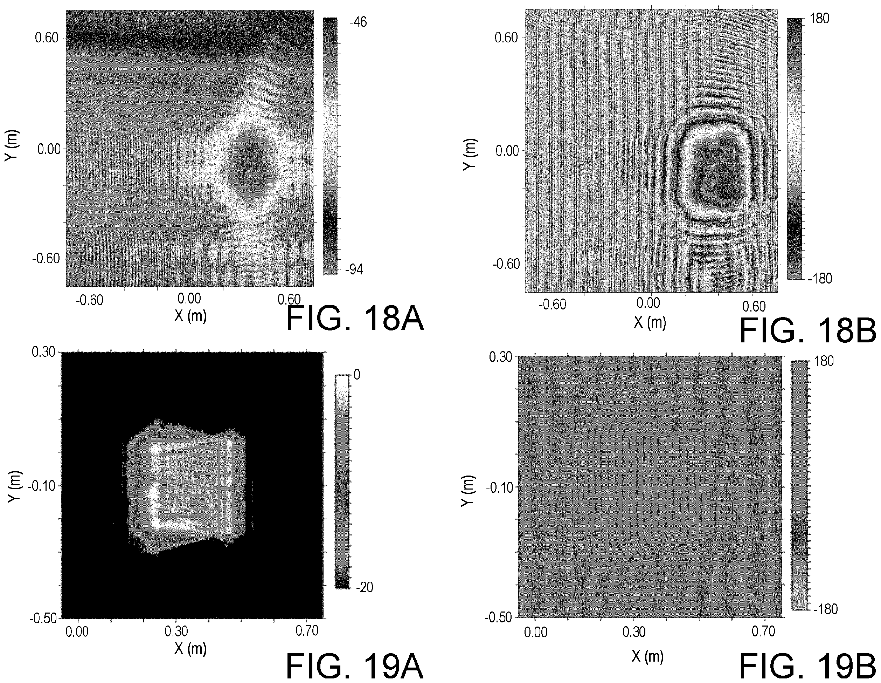

FIG. 18A is a near-field amplitude diagram of a 30 cm ×30 cm metal plate according to an exemplary embodiment of the present disclosure, and FIG. 18B is a near-field phase diagram of the 30 cm ×30 cm metal plate according to an exemplary embodiment of the present disclosure.

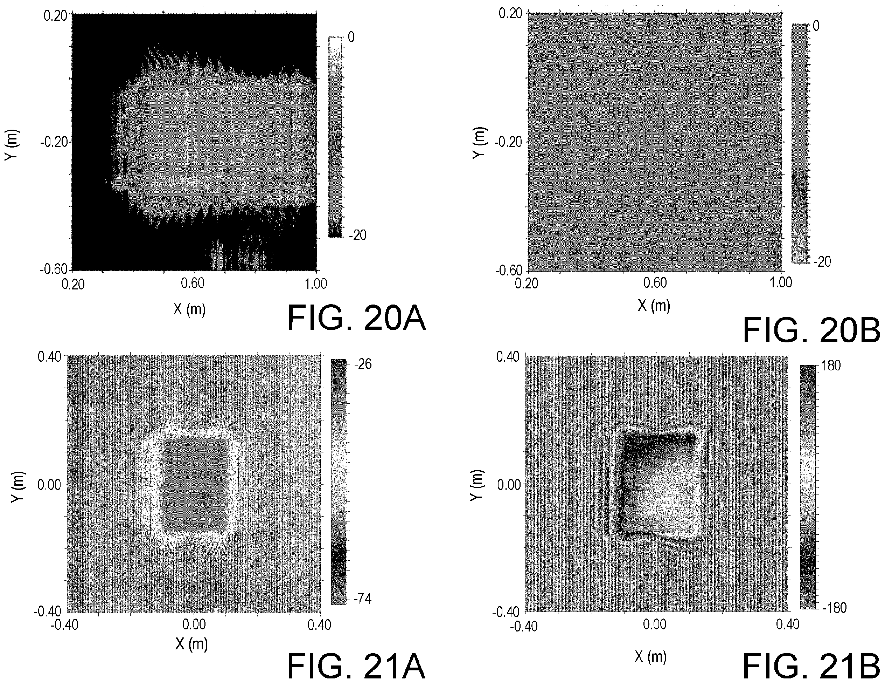

FIG. 19A is a hologram amplitude diagram of a 30 cm ×30 cm metal plate according to an exemplary embodiment of the present disclosure, and FIG. 19B is a hologram phase diagram of the 30 cm ×30 cm metal plate according to an exemplary embodiment of the present disclosure. FIG. 20A is a hologram amplitude diagram of 40 cm ×40 cm passive RIS according to an exemplary embodiment of the present disclosure, and FIG. 20B is a hologram phase diagram of the 40 cm ×40 cm passive RIS according to an exemplary embodiment of the present disclosure. These figures are hologram current imaging for bistatic tests on metal plates and passive RIS's in which the incidence angle is 30 degrees. In FIG. 19A and FIG. 19B, the testing device 130 is the 30 cm ×30 cm metal plate. In FIG. 20A and FIG. 20B, the testing device 130 is the 40 cm ×40 cm passive RIS.

FIG. 21A is a hologram amplitude diagram of a 30 cm ×30 cm metal plate according to an exemplary embodiment of the present disclosure, and FIG. 21B is a hologram phase diagram of the 30 cm ×30 cm metal plate according to an exemplary embodiment of the present disclosure. These figures are hologram current imaging for bistatic tests on metal plates and passive RIS's in which the incidence angle is 45 degrees. In FIG. 21A and FIG. 21B, the testing device 130 is the 30 cm ×30 cm passive RIS. All amplitude and phase distribution diagrams shown in FIGs' 18s, 19s, 20s, and 21s have been based in the sense of recording vertically polarized field component using nearfield probe antenna 151 following by emitting vertically polarized RF source, MW, from the signal source 140 at the CR reflector focus side, FP, according to an exemplary embodiment of the present disclosure.

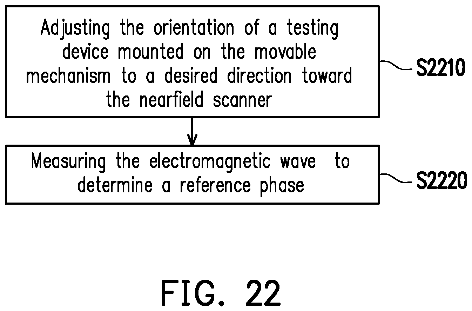

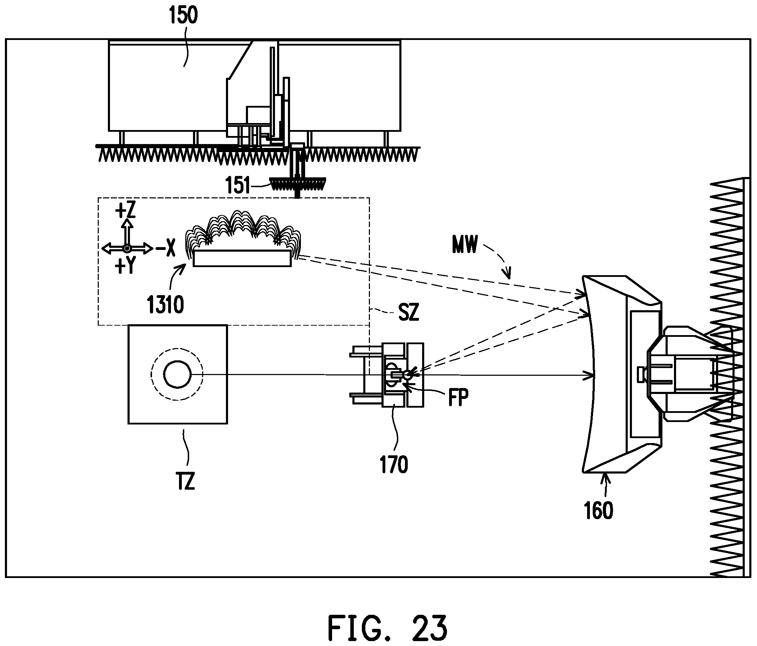

FIG. 22 is a flow chart that illustrates a near-field over-the-air (OTA) scanning method according to an exemplary embodiment of the present disclosure. Referring to FIG. 22, the processor 180 may adjust the orientation of the testing device 130 mounted on the movable mechanism to a desired direction toward the nearfield scanner 150 through the movable mechanism 120 (step S2210). FIG. 23 is a schematic diagram that illustrates a near-field OTA scan scene according to an exemplary embodiment of the present disclosure. Referring to FIG. 23, the desired direction makes an angle within a range greater than 0 degree and less than 60 degrees relative to the aforementioned second reference line (e.g., along the axis Z). For example, 0 degree relative to the axis Z as shown in FIG. 23. Furthermore, the testing device 1310 is moved to the scan coverage SC of the nearfield scanner 150.

The testing device 1310 is the signal source 140. In one embodiment, the processor 180 may specify a target beam or a target frequency of the testing device 1310 which emits the electromagnetic wave. The processor 180 may select one of the beams as the target beam, and control the testing device 1310 to radiate at the target beam.

Referring to FIG. 22 and FIG. 23, the processor 180 may measure the electromagnetic wave through the receiver 170 located at the focal point FP of the parabolic surface of the CR reflector 160, to determine a reference phase (step S2220) through the use of a vector network analyzer at the receiver 170 side. The CR feed (e.g., the receiver 170) can be slightly defocused in an optimized way (by using a separate feed antenna nearby the CR feed for collecting from the CR reflector 160 leaked RF Carrier (with/without protocol/modulation) from the testing device 1310 at the transmitter mode serving as a fixed phase reference of the OTA RF signature of the receiver 170.

In one embodiment, the processor 180 may tune and/ or optimize the performance of the testing device 130 such as an active electronically scanned array (AESA) from back-projected current distributions diagnosis of UUT at specific antenna beam state/ configuration of RF carrier frequencies with/without protocol/air-interface due to the regenerated phase reference and amplitude information of the OTA RF signature of the receiver 170 based on radiating near-field aperture to applicable equivalent physical aperture transformation algorithm.

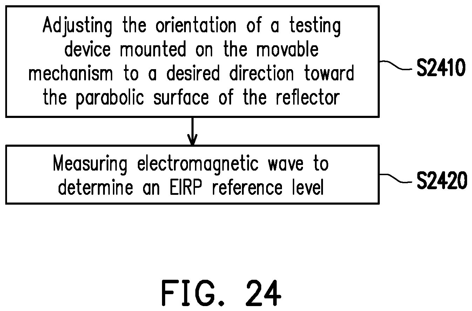

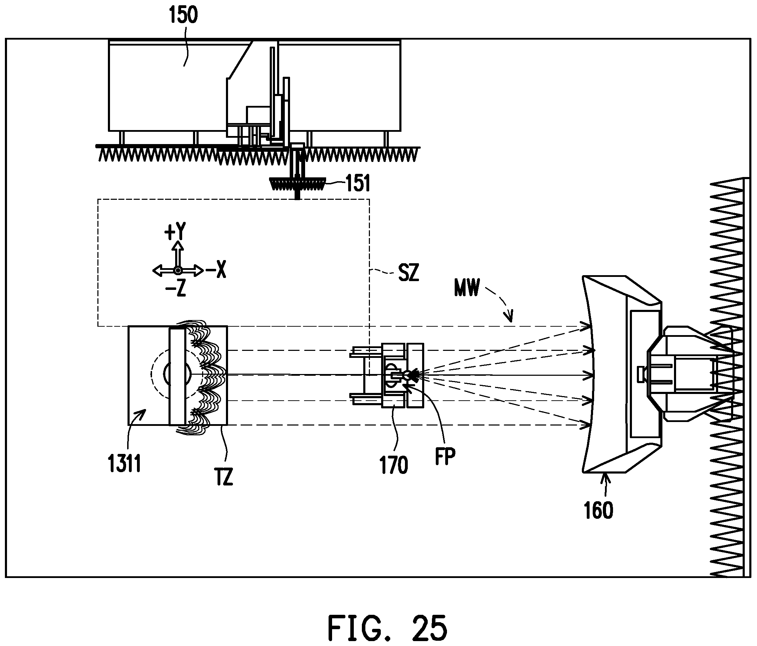

FIG. 24 is a flow chart that illustrates an effective isotropic radiated power (EIRP) calibrating method according to an exemplary embodiment of the present disclosure. Referring to FIG. 24, the processor 180 may adjust the orientation of the testing device 130 mounted on the movable mechanism 120 through the movable mechanism 120 to a desired direction toward the parabolic surface of the CR reflector 160 (step S2410). FIG. 25 is a schematic diagram that illustrates the EIRP calibration scene of a testing device 1311 according to an exemplary embodiment of the present disclosure. Referring to FIG. 25, the testing device 130 is moved to the testing zone TZ. The desired direction to where the orientation of the testing device 130 directs toward the direction where the receiver 170 directs. The desired direction makes an angle within a range greater than 0 degree and less than 60 degrees relative to the aforementioned second reference line (e.g., along the axis -X). For example, 0 degree relative to the axis -X as shown in FIG. 25.

The testing device 1311 is the signal source 140. In one embodiment, the processor 180 may specify a target beam or a target frequency of the testing device 1311 which emits the electromagnetic wave. The processor 180 may select one of the beams as the target beam, and control the testing device 1310 to radiate at the target beam. Within the CR quiet zone region (e.g., the testing zone TZ), the physical broadside of the AESA/AUT is deployed and realigned at the transmitter and OTA mode operation coinciding the broadside of CATR for calibrating accurate EIRP level of AESA at transmitter mode of the associated controlled scan-beam of RF Carrier (with/without air-interface) at AUT broadside direction.

The processor 180 may measure the electromagnetic wave through a receiver 170 located at the focal point FP of the parabolic surface of the CR reflector 160 to determine an effective isotropic radiated power (EIRP) reference level (step 2420). The calibrated EIRP spectrum collected at the focal point FP of the CR reflector 160 with RF Carrier (with/without air-interface) from stationary AESA/AUT (i.e., the testing device 130) at specific AESA beam state/configuration of RF carrier is served as calibrated EIRP reference level at AUT broadside direction for all Near-Field OTA Scan derived far-field 3D EIRP patterns.

In summary, in the testing system and the testing method of the embodiments of the disclosure, a versatile plane-wave emulation range implemented for UUT bistatic & AESA OTA properties evaluation over modulated RF carrier undergoing nearfield scan & processing enabled by CR-built phase reference with key test range configuration parameters are proposed. Therefore, the reliability and efficiency of UL transmission may be improved, and the embodiment planar wavefront generated by the CR (Compact Range) emulates realistic scenes of actual RF signature emitted from distant RF sources (such as 5G/6G/LEO base-stations) illuminating over a physical aperture of AUT/UUT/RIS. Bistatic/irradiated far-field 3D angular responses derived from nearfield scanning per every scene of scattered /irradiated field distribution of AUT/UUT/RIS are acquired by the side-deployed nearfield scanner. Side-deployed nearfield scanner employed at OTA Scan Mode for VNA-based 3D antenna pattern measurement/aperture diagnosis of fixed AESA at transmitter mode with controlled scan-beam of RF carrier referenced to CR feed-collected Stationary AUT phase reference. CR mode operations of stationary AESA at transmitter mode featuring accurate RF Carrier EIRP references (w./wt. modulation) are associated for generating 3D ERIP patterns of all scanned beams of the same AESA per normalized 3D patterns through near-field OTA mode operations. It is capable of tuning and optimizing RIS/AESA performance at transmitter mode from back-projected current distributions diagnosis of UUT at specific antenna beam state/configuration of RF carrier frequencies with or without modulation.

## Claims

1. A testing system (1), comprising:
a movable mechanism (120, 121, 122, 123);
a testing device (130, 1310), mounted on the movable mechanism (120, 121, 122, 123), and used for emitting or reflecting an electromagnetic wave (MW);
a signal source (140), configured to emit the electromagnetic wave (MW);
a nearfield scanner (150), used for measuring the incoming electromagnetic wave (MW);
a compact range (CR) reflector (160), having a parabolic surface used for reflecting the electromagnetic wave (MW); and
a processor (180), coupled to the movable mechanism (120, 121, 122, 123), the signal source (140), and the nearfield scanner (150), and configured to:
adjust, through the movable mechanism (120, 121, 122, 123), an orientation of the testing device (130, 1310);
emit, through the signal source (140), the electromagnetic wave (MW); and
determine, through the nearfield scanner (150), electromagnetic field information of the electromagnetic wave (MW).

2. The testing system (1) according to claim 1, wherein the parabolic surface of the CR reflector (160) has a focal point (FP), and the signal source (140) is located at the focal point (FP), the signal source (140) is located between the testing device (130, 1310) and the CR reflector (160), and the testing device (130, 1310) reflects the electromagnetic wave (MW) reflected by the CR reflector (160).

3. The testing system (1) according to claim 1 or 2, wherein the processor (180) is further configured to:
adjust, through the movable mechanism (120, 121, 122, 123), a position of the testing device (130, 1310) to be located within a test zone (TZ), wherein a diameter (D1, D2) of the test zone (TZ) is D, a size of the reflector (160) is 2*D, a focal length (F2) of the reflector (160) is equal to or larger than 2*D, and a distance (F1) between the reflector (160) and the testing device (130, 1310) is equal to or larger than 4*D.

4. The testing system (1) according to claim 3, further comprising:
a chamber (110), having an internal space (111), wherein a width (W) of the internal space (111) corresponding to a first pair of opposite sides is 3*D, a length (L) of the internal space (111) corresponding to a second pair of opposite sides is equal to or larger than 6.5*D, a height (H) of the internal space (111) corresponding to a third pair of opposite sides is 3*D, distances between the first pair of opposite sides and their respective nearest boundaries of the test zone (TZ) are both D, a distance between one of the second pair of opposite sides and its respective nearest boundary of the test zone (TZ) is D, a distance between another of the second pair of opposite sides and its respective nearest boundary of the test zone (TZ) is equal to 4.5*D or larger than 4.5*D, and distances between the pair of opposite third sides and their respective nearest boundaries of the test zone (TZ) are both D.

5. The testing system (1) according to claim 4, wherein the nearfield scanner (150) has a probe (151), and the probe (151) stands vertically at one of the first pair of opposite sides of the internal space (111).

6. The testing system (1) according to claim 2, wherein the processor (180) is further configured to:
adjust, through the movable mechanism (120, 121, 122, 123), the orientation of the testing device (130, 1310) to a desired direction, wherein the desired direction makes an angle within a range greater than 0 degree and less than 90 degrees relative to a first reference line (RL1), and the desired direction makes an angle greater than 0 degree and less than 90 degrees relative to a second reference line (RL2), the first reference line (RL1) is parallel to a line connected between the testing device (130, 1310) and the CR reflector (160), the second reference line (RL2) is parallel to a line connected between the testing device (130, 1310) and the nearfield scanner (150), and the first reference line (RL1) is vertical to the second reference line (RL2).

7. The testing system (1) according to claim 4, wherein the nearfield scanner (150) is configured, at a distance from a surface of scan, where the tip of the probe antenna of the nearfield scanner (150) is located, 1.3*D from the center of test zone (TZ) of the internal space (111), and with the negative X scan boundary of scan coverage (SZ) extends no more than 1.75*D from a line connected between the center of the test zone (TZ) and the nearfield scanner (150), an overall length of the scan coverage (SZ) corresponding to the second pair of opposite sides is equal to or larger than 2.75*D, a height of the scan coverage (SZ) corresponding to the third pair of opposite sids is equal to or larger than 2*D.

8. The testing system (1) according to any one of the preceding claims, wherein the CR reflector (160) is a roll-edged reflector.

9. The testing system (1) according to any one of the preceding claims , wherein the testing device (130, 1310) is the signal source (140), and the testing system (1) further comprises:
a receiver (170), coupled to the processor (180) and located at a focal point (FP) of the parabolic surface of the CR reflector (160), wherein the processor (180) is further configured to:
adjust, through the movable mechanism (120, 121, 122, 123), the orientation of the testing device (130, 1310) to a desired direction, wherein the desired direction makes an angle within a range greater than 0 degree and less than 90 degrees relative to a second reference line (RL2), the second reference line (RL2) is parallel to a line connected between the testing device (130, 1310) and the nearfield scanner (150) and vertical to a first reference line (RL1), and the first reference line (RL1) is parallel to a line connected between the testing device (130, 1310) and the CR reflector (160); and
receive, through the receiver (170), the electromagnetic wave (MW) reflected by the CR reflector (160).

10. The testing system (1) according to claim 9, further comprising:
a chamber (110), having an internal space (111), wherein a width (W) of the internal space (111) corresponding to a first pair of opposite sides is 3*D, D is a reference length, a length (L) of the internal space (111) corresponding to a second pair of opposite sides is equal to or larger than 6.5*D, a height (H) of the internal space (111) corresponding to a third pair of opposite sides is 3*D, and the processor (180) is further configured to:
adjust, through the movable mechanism (120, 121, 122, 123), a position of the testing device (130, 1310) to be located within a scan coverage (SZ) of the nearfield scanner (150), configured at the distance from the surface of scan, where the tip of the probe antenna of the nearfield scanner (150) is located, 1.3*D from the center of test zone (TZ) of the internal space (111), and with the negative X scan boundary of scan coverage (SZ) extends no more than 1.75*D from a line connected between the center of the test zone (TZ) and the nearfield scanner (150), an overall length of the scan coverage (SZ) corresponding to the second pair of opposite sides is equal to or larger than 2.75*D, a height (SCY) of the scan coverage (SZ) corresponding to the third pair of opposite sides is equal to or larger than 2*D.

11. The testing system (1) according to claim 1, wherein the testing device (130, 1310) is the signal source (140), and the testing system (1) further comprises:
a receiver (170), coupled to the processor (180) and located at a focal point (FP) of the parabolic surface of the CR reflector (160), wherein the processor (180) is further configured to:
adjust, through the movable mechanism (120, 121, 122, 123), the orientation of the testing device (130, 1310) to a desired direction, wherein the desired direction makes an angle being 0 degree relative to a first reference line (RL1), the first reference line (RL1) is parallel to a line connected between the testing device (130, 1310) and the CR reflector (160); and
receive, through the receiver (170), the electromagnetic wave (MW) reflected by the CR reflector (160); or
the processor (180) is further configured to:
adjust, through the movable mechanism (120, 121, 122, 123), a position of the testing device (130, 1310) to be located within a test zone (TZ), wherein a diameter (D1, D2) of the test zone (TZ) is D, a size of the CR reflector (160) is 2*D, a focal length (F2) of the CR reflector (160) is equal to or larger than 2*D, and a distance between the CR reflector (160) and the testing device (130, 1310) is equal to or larger than 4*D.

12. A testing method, **characterized in that** the testing method comprises:
adjusting, through a movable mechanism (120, 121, 122, 123), an orientation of a testing device (130, 1310) mounted on the movable mechanism (120, 121, 122, 123);
emitting an electromagnetic wave (MW); and
determining, through a nearfield scanner (150), electromagnetic field information of the electromagnetic wave (MW) reflected or emitted by the testing device (130, 1310) or reflected by a compact range (CR) reflector (160), wherein the CR reflector (160) has a parabolic surface used for reflecting the electromagnetic wave (MW).

13. The testing method according to claim 12, wherein the parabolic surface of the CR reflector (160) has a focal point (FP), and a signal source (140) that emits the electromagnetic wave (MW) is located at the focal point (FP), the signal source (140) is located between the testing device (130, 1310) and the CR reflector (160), and the testing device (130, 1310) reflects the electromagnetic wave (MW) reflected by the CR reflector (160), and the testing method further comprises:
obtaining, through the nearfield scanner (150), first data of the electromagnetic field information corresponding to a metal plane serving as the testing device (130, 1310);
obtaining, through the nearfield scanner (150), second data of the electromagnetic field information corresponding to a RIS (134, 136, 138, 139) serving as the testing device (130, 1310); and
calibrating a target peak irradiance or reflectivity of the RIS (134, 136, 138, 139) by comparing the first data and the second data.

14. The testing method according to claim 12 or 13, further comprising:
adjusting, through the movable mechanism (120, 121, 122, 123), a position of the testing device (130, 1310) to be located within a test zone (TZ), wherein a diameter (D1, D2) of the test zone (TZ) is D, a size of the CR reflector (160) is 2*D, a focal length (F2) of the CR reflector (160) is equal to or larger than 2*D;
obtaining, through the nearfield scanner (150), third data of the electromagnetic field information corresponding to an RIS (134, 136, 138, 139) serving as the testing device (130, 1310) located at the test zone (TZ).

15. The testing method according to claim 12, 13 or 14, wherein
adjusting the orientation of the testing device (130, 1310) comprises:
adjusting, through the movable mechanism (120, 121, 122, 123), the orientation of the testing device (130, 1310) mounted on the movable mechanism (120, 121, 122, 123) to a desired direction toward the nearfield scanner (150);
measuring, through a receiver (170) located optimally nearby the focal point (FP) of the parabolic surface of the CR reflector (160), the electromagnetic wave (MW) to determine a reference phase; and
specifying a target beam or a target frequency of the testing device (130, 1310) that emits the electromagnetic wave (MW); or
adjusting the orientation of the testing device (130, 1310) comprises:
adjusting, through the movable mechanism (120, 121, 122, 123), the orientation of the testing device (130, 1310) mounted on the movable mechanism (120, 121, 122, 123) to a desired direction toward the parabolic surface of the CR reflector (160); and
measuring, through a receiver (170) located at a focal point (FP) of the parabolic surface of the CR reflector (160), the electromagnetic wave (MW) to determine an effective isotropic radiated power (EIRP) reference level.
